Europäisches Patentamt

European Patent Office

Office européen des brevets

(19)

(11) EP 1 160 884 A2

(12) EUROPÄISCHE PATENTANMELDUNG

(43) Veröffentlichungstag:
05.12.2001 Patentblatt 2001/49

(51) Int Cl.⁷: H01L 39/16

(21) Anmeldenummer: 01810468.7

(22) Anmeldetag: 14.05.2001

(84) Benannte Vertragsstaaten:
AT BE CH CY DE DK ES FI FR GB GR IE IT LI LU
MC NL PT SE TR
Benannte Erstreckungsstaaten:
AL LT LV MK RO SI

(30) Priorität: 31.05.2000 DE 10027243

(71) Anmelder: ABB RESEARCH LTD.
8050 Zürich (CH)

(72) Erfinder:
• Chen, Makan
5405 Baden-Dättwil (CH)
• Paul, Willi
5430 Wettingen (CH)

(74) Vertreter: ABB Patent Attorneys
c/o ABB Business Services Ltd,
Intellectual Property (SLE-I),
Haselstrasse 16/699
5401 Baden (CH)

(54) Hochtemperatursupraleiteranordnung

(57) Bei Hochtemperatursupraleiteranordnungen mit einem Supraleiter 1 und einem elektrischen Bypass 2 sind deren thermische Ausdehnungskoeffizienten $\alpha_{SC}$, $\alpha_{BP}$ so gewählt, dass der Bypass den Supraleiter unter kompressiven Druck setzt. Erfindungsgemäss ist dies auch dann der Fall, wenn eine erhebliche Temperaturdifferenz $\Delta T$ zwischen Bypass und Supraleiter, wie sie bei Strombegrenzern durch Fehlerströme induziert werden kann, auftritt. Durch den thermomechanischen kompressiven Druck wird die Ausbildung oder Vergrösserung von Rissen im Supraleiter verhindert. Der Bypass ist vorzugsweise aus Stahl und auf den Supraleiter kraftschlüssig aufgelötet oder aufgeklebt.

Fig. 1

EP 1 160 884 A2

**Beschreibung**

TECHNISCHES GEBIET

Die vorliegende Erfindung bezieht sich auf das Gebiet der Hochtemperatursupraleitung. Sie betrifft eine Hochtemperatursupraleiteranordnung gemäss dem Oberbegriff des Patentanspruchs 1 sowie ein Verfahren zu deren Herstellung gemäss dem Oberbegriff des Patentanspruchs 7.

STAND DER TECHNIK

In der Europäischen Patentanmeldung EP-A 0 911 889 ist eine Hochtemperatursupraleiteranordnung zur Verwendung in einem Strombegrenzer dargestellt. Die Anordnung umfasst eine supraleitende Schicht und eine als elektrischer Bypass ausgebildete, gelochte Stahlplatte, welche mit der supraleitenden Schicht einen Leiterverbund bildet. Zur Verbesserung des Kontaktwiderstandes zwischen Supraleiter und Bypass ist letzterer mittels eines leitfähigen Epoxidharzes auf den Supraleiter aufgeklebt. Zur Kühlung auf Betriebstemperatur wird der Leiterverbund mit einem Kühlmedium, vorzugsweise mit flüssigem Stickstoff $LN_2$, in thermischen Kontakt gebracht.

Eine Schwäche der Hochtemperatursupraleiter liegt in ihrer Anfälligkeit gegenüber der Bildung von Rissen, welche in der fehlenden Duktilität oder plastischen Verformbarkeit des keramischen Materials begründet liegt. Zudem entstehen an bereits existierenden Mikrorissen bei Zugbelastung Spannungsspitzen, die zum weiteren Wachsen Letzterer führen. Die Ursache der mechanischen Zugspannungen sind z.B. elektromagnetische Kräfte oder thermomechanische Spannungen in Zusammenhang mit Temperaturgradienten und/oder unterschiedliche thermischen Ausdehnungskoeffizienten von Supraleiter und Bypass. Sowohl polykristalline Supraleiter wie auch dünne, epitaktisch auf einem Substrat aufgewachsene Schichten sind betroffen, wobei für die Letztgenannten bei Temperaturänderungen das Substrat die resultierende Längenausdehnung dominiert und entsprechend präpariert werden muss.

Um Zug- oder Druckbelastungen im Supraleiter zu reduzieren, wird üblicherweise darauf geachtet, dass die thermischen Ausdehnungskoeffizienten von Supraleiter und Bypass möglichst übereinstimmen. Dies ist aber nur solange erfolgversprechend, als beide Komponenten des Leiterverbundes dieselbe Betriebstemperatur aufweisen.

In der DE 4418050 A1 ist ein hohlzylindrischer Hochtemperatursupraleiter angegeben, auf welchen aussenseitig eine 10-100 μm dicke elektrische Bypassschicht in Form einer Silber oder Aluminiumfolie aufgebracht ist. Um den Übergangswiderstand zwischen dem Supraleiter und der metallischen Bypass-Schicht zu verringern, wird der Hohlzylinder bei Zimmertemperatur mit einer unter Zugspannung stehenden mechanischen Armierung aus einem elastischen Stahldraht oder einem Band aus Glasfasergewebe umwickelt. Anschliessend wird die Armierung mittels eines Lotes oder eines Kunstharzes fixiert. Somit entsteht im Supraleitermaterial ein kompressiver Druck mit Komponenten senkrecht und parallel zur Hohlzylinderoberfläche.

DARSTELLUNG DER ERFINDUNG

Aufgabe der vorliegenden Erfindung ist es, bei einer Hochtemperatursupraleiteranordnung der eingangs genannten Art die Entstehung oder Vergrösserung von Rissen senkrecht zur Stromflussrichtung im Supraleiter zu vermeiden. Diese Aufgabe wird durch eine Hochtemperatursupraleiteranordnung mit den Merkmalen des Patentanspruchs 1 und ein Verfahren zu deren Herstellung mit den Merkmalen des Patentanspruchs 7 gelöst.

Der Erfindung liegt die Erkenntnis zugrunde, dass sich die Komponenten des Leiterverbundes im Betrieb nicht notwendigerweise immer auf derselben Temperatur befinden. Insbesondere bei Strombegrenzern erwärmen sich der Supraleiter und der elektrische Bypass im Begrenzungsfall unterschiedlich schnell, und dabei kann der Bypass eine viel höhere Temperatur erreichen als der Supraleiter.

Kern der Erfindung ist es, Zugspannungen im Hochtemperatursupraleiter zu unterbinden, indem dieser unter einen kompressiven Druck gesetzt wird, welchen der mit dem Supraleiter verbundene elektrische Bypass thermomechanisch erzeugt. Die Supraleiteranordnung ist so ausgelegt, dass dieser kompressive Druck bei allen Temperaturkonfigurationen, welche beim Abkühlen und beim Einsatz der Anordnung und insbesondere im Begrenzungsfall vorkommen können, aufrechterhalten wird.

In einer ersten bevorzugten Ausführungsform sind die thermischen Ausdehnungskoeffizienten von Supraleiter und Bypass und die im Betrieb auftretenden Temperaturen so aufeinander abgestimmt, dass beim Abkühlen der Anordnung von einer Temperatur $T_0$ auf eine mögliche Kombination von momentaner Supraleiterund Bypasstemperatur die spezifische Längenänderung des Bypass grösser ist als diejenige des Supraleiters.

In einer zweiten bevorzugten Ausführungsform ist die Supraleiteranordnung so ausgelegt und sind die Betriebsbedingungen so gewählt, dass die im Begrenzungsfall auftretende maximale Betriebstemperatur des Bypass einen gewissen Wert nicht überschreitet, welcher Wert proportional zur Differenz der thermischen Ausdehnungskoeffizienten von Bypass und Supraleiter ist.

EP 1 160 884 A2

Der Bypass ist vorteilhafterweise symmetrisch zum Supraleiter, d.h. bei einer flachen, bandförmigen Anordnung beidseits des Supraleiters, anzubringen, um bimetallartige Distorsionen zu vermeiden. Werden zwei durch einen Isolator getrennte supraleitende Schichten vom Bypass umgeben, kann in ersteren der Strom zwecks Verringerung von Wechselstromverlusten in entgegengesetzten Richtungen fliessen.

Das erfindungsgemässe Verfahren zeichnet sich dadurch aus, dass Supraleiter und Bypass ohne Vorspannung in Stromflussrichtung bei einer Herstelltemperatur $T_0$ in Kontakt gebracht werden. Dank der Abstimmung zwischen den maximal zu erwartenden Temperaturgradienten und den thermischen Ausdehnungskoeffizienten von Bypass und Supraleiter kann darauf verzichtet werden, den Supraleiter bereits bei der Herstelltemperatur unter Druck zu setzen.

Weitere vorteilhafte Ausführungsformen gehen aus den abhängigen Patentansprüchen hervor.

KURZE BESCHREIBUNG DER FIGUREN

Nachfolgend wird die Erfindung anhand von Ausführungsbeispielen im Zusammenhang mit den Zeichnungen näher erläutert. Es zeigen

Fig.1 eine Hochtemperatursupraleiteranordnung mit einer erfindungsgemässen Bypassschicht zur elektrischen Stabilisierung und thermomechanischen Komprimierung des Supraleiters,

Fig.2 eine Hochtemperatursupraleiteranordnung gemäss einer bevorzugten Ausführungsform mit einer Zwischenschicht zwischen Supraleiter und Bypass, und

Fig.3 eine Hochtemperatursupraleiteranordnung mit zwei durch einen Isolator getrennten supraleitenden Schichten.

Die in den Zeichnungen verwendeten Bezugszeichen sind in der Bezugszeichenliste zusammengefasst. Grundsätzlich sind gleiche Teile mit denselben Bezugszeichen versehen.

WEGE ZUR AUSFÜHRUNG DER ERFINDUNG

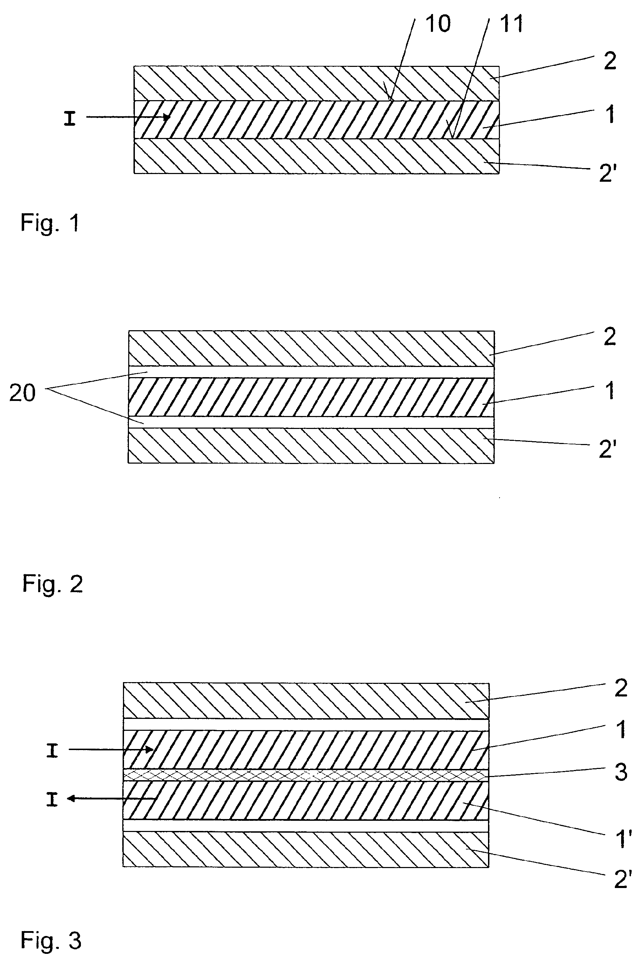

In Fig.1 ist ein Ausschnitt aus einem Querschnitt durch eine Hochtemperatursupraleiteranordnung, wie sie beispielsweise in Strombegrenzern Verwendung findet, dargestellt. Ein Hochtemperatursupraleiter 1 ist über eine erste Hauptfläche 10 mit einer elektrischen Bypassschicht 2 flächenhaft stoff- und kraftschlüssig verbunden. Der Strom fliesst in einer Stromflussrichtung I parallel zur ersten Hauptfläche 10 durch den Leiterverbund aus Supraleiter 1 und Bypass 2. Bei drahtförmigen Anordnungen mit annähernd quadratischen oder kreisrunden Querschnitten kann der Bypass den supraleitenden Kern allseitig umgeben. Im Falle einer flachen, bandartigen Anordnung ist es vorteilhaft, zumindest über eine zweite Hauptfläche 11, welche der ersten Hauptfläche 10 gegenüberliegt, eine weitere Bypassschicht 2' mit dem Supraleiter 1 in Kontakt zu bringen. Dadurch ist sichergestellt, dass die thermisch induzierte Längenänderung parallel zur Stromflussrichtung I verläuft und zu keiner bimetallartigen Distorsion der Anordnung führt.

In Fig.2 sind zwischen den beiden Schichten 1,2 Zwischenschichten 20 zur Verbesserung des elektrischen Kontaktes zwischen Supraleiter 1 und Bypass 2 und/oder zur mechanischen Fixierung des Bypass 2 dargestellt. Diese Zwischenschichten 20 umfassen beispielsweise eine Lotschicht oder einen ausgehärteten, leitenden Polymerverbund. Weitere, in Fig.2 nicht gezeigte Schichten beispielsweise aus Glasfaserkunststoff, welche zur mechanischen Verstärkung der Anordnung dienen, sind auch möglich.

In Fig.3 ist eine Anordung dargestellt mit zwei supraleitenden Schichten 1,1', welche voneinander durch eine Schicht eines elektrischen Isolators 3 getrennt sind. Die Stromflussrichtungen I,I' in diesen zwei Schichten 1,1' ist annähernd antiparallel oder entgegengesetzt, dadurch werden Wechselstromverluste im Supraleiter reduziert.

Das zugrundeliegende Problem der Rissbildung ist nicht auf einen bestimmten Hochtemperatursupraleiter-Typ und/oder ein bestimmtes Verfahren zu seiner Herstellung beschränkt. In Strombegrenzeranwendungen eingesetzt wird beispielsweise schmelzprozessiertes $Bi_2Sr_2CaCu_2O_8$ als polykristallines Bulkmaterial mit Schichtdicken vorzugsweise zwischen 50 und 1000 μm. Dieses wird hergestellt, indem eine Grünfolie aus dem entsprechenden Supraleiterpulver und einem Binder sowie Lösungsmitteln einer Temperaturbehandlung zugeführt wird. Dabei wird zuerst der Binder ausgebrannt und anschliessend der Supraleiter unter kontrollierter Sauerstoffatmosphäre partiell aufgeschmolzen. Als normalleitender Bypass geeignet sind metallische Legierungen auf Stahl- oder Nickelbasis mit einem spezifischen Widerstand bei Raumtemperatur von mehr als 10 μΩcm. Die Bypassschichtdicke ist hauptsächlich durch den erforderlichen normalleitenden Gesamt-Bypasswiderstand bestimmt und beträgt zwischen 0.1 und 2 mm.

Im Begrenzungsfall, d.h. im Anschluss an das Auftreten eines Fehlerstromes, welcher die kritische Stromstärke des Supraleiters übersteigt, beginnt sich ein Spannungsabfall auszubilden und durch die erzeugte Joul'sche Wärme heizt sich der Supraleiter auf. Spätestens bei Erreichen der kritischen Temperatur $T_c$ des Supraleiters ist der Widerstand im Supraleiter so gross, dass der begrenzte Fehlerstrom nur noch durch den metallischen Bypass fliesst. Somit wärmt sich nur noch der Bypass weiter auf und es können sich beträchtliche Temperaturgradienten $\Delta T$ zwischen der momentanen Temperatur des Bypass ($T_{BP}$) und des Supraleiter ($T_{SC}$) ausbilden. Die Supraleitertemperatur $T_{SC}$ wird also nur noch langsam und unwesentlich über die kritische Temperatur $T_C$ hinaus zunehmen. Die genannten Temperaturen sind nicht notwendigerweise über die gesamte Länge des Leiterverbundes konstant, sondern ändern im Allgemeinen in Abhängigkeit von Ort und Zeit. Hingegen sind $T_{BP}$ und $T_{SC}$ jeweils gleichzeitig und an unmittelbar benachbarten Stellen des Bypass respektive des Supraleiters zu bestimmen. Fehlerströme treten nicht nur in Strombegrenzern auf, auch bei supraleitenden Transformatoren oder Übertragungskabeln muss damit gerechnet werden. Wie eingangs dargelegt führen derartige Temperaturdifferenzen zu unkontrollierten Spannungen auf den Supraleiter und zur Bildung oder Vergrösserung von Rissen.

Zur Vermeidung der genannten Spannungen wird erfindungsgemäss vorgeschlagen, den elektrischen Bypass 2 zur Erzeugung eines kompressiven Druckes auf den Supraleiter 1 einzusetzen und dafür zu sorgen, dass der genannte Druck auch im Begrenzungsfall, d.h. falls die Temperatur $T_{BP}$ des Bypass 2 über der Temperatur $T_{SC}$ des Supraleiters 1 liegt, aufrechterhalten wird. Im Gegensatz zum Fall einer für den Leiterverbund homogenen Temperatur (d.h. $T_{BP} = T_{SC}$) ist es dazu im Allgemeinen nicht ausreichend, den thermischen Ausdehnungskoeffizienten $\alpha_{BP}$ der Bypassschicht 2 nur leicht grösser zu wählen als den thermischen Ausdehnungskoeffizienten $\alpha_{SC}$ der Supraleiterschicht 1. Für einen wirksamen Schutz der Anordnung ist es wesentlich, zumindest in einer Hauptstromflussrichtung I einen derartigen Druck aufzubauen, um Risse senkrecht zu I zu unterbinden. Je nachdem, wie der besagte Druck erzeugt wird, können sich auch Druckkomponenten senkrecht zu I ergeben.

Der Verbund aus Supraleiter 1 und Bypass 2 wird bei einer bestimmten, im Folgenden mit $T_0$ bezeichneten Herstelltemperatur fabriziert. Diese Temperatur $T_0$ kann die Raumtemperatur sein oder in Funktion der Zwischenschicht 20 die Schmelztemperatur des Lotes respektive die Aushärtetemperatur des Polymerverbundes. Nach erfolgter Präparation des Verbundes ist dieser mechanisch fest, d.h. die Komponenten 1,2 des Verbundes gleiten nicht mehr aneinander, sondern weisen bei $T \neq T_0$ parallel zur Hauptfläche 10 dieselbe *relative* Längenänderung auf. Dementsprechend darf die Zwischenschicht 20 nicht nachgiebig sein, eine zu dicke Schicht aus Silber beispielsweise könnte wegen ihrer Verformbarkeit den gewünschten Druckaufbau im Supraleiter verhindern. Bei unterschiedlichen thermischen Ausdehnungskoeffizienten und/oder falls sich die Komponenten auf unterschiedlichen Temperaturen befinden, werden in beiden Komponenten thermomechanische Spannungen induziert. Beispielsweise tritt bei einer langsamen Abkühlung auf Betriebstemperatur im Körper mit dem kleineren thermischen Ausdehnungskoeffizienten eine Druck- und im anderen eine Zugbelastung auf.

Eine Abschätzung für die erforderliche Auslegung der hochtemperatursupraleiteranordnung ergibt sich aus folgender Überlegung: Eine Supraleiter und ein gleich langer elektrischer Bypass werden bei der Temperatur $T_0$ nebeneinandergelegt und anschliessend auf die Temperatur $T_{SC}$ (Supraleiter) respektive $T_{BP}$ (Bypass) abgekühlt. Es stellt sich bei mechanisch kraftschlüssig verbundenen Schichten ein kompressiver Druck auf den Supraleiter ein, falls die spezifische Längenänderung des Bypass grösser ist als diejenige des Supraleiters:

$$\alpha_{BP} \cdot (T_0 - T_{BP}) > \alpha_{SC} \cdot (T_0 - T_{SC}).$$

Diese erste Ungleichung ist äquivalent zu:

$$\frac{\alpha_{BP} - \alpha_{SC}}{\alpha_{BP}} > \frac{T_{BP} - T_{SC}}{t_0 - T_{SC}}$$

Unter der Annahme, dass sich im Begrenzungsfall sowohl der Supraleiter wie auch der Bypass über $T_C$ erwärmen, lautet eine für die erste Ungleichung hinreichende Bedingung für die dabei zu erwartende maximale Bypasstemperatur $T_{BP}^{max}$:

$$\frac{T_{BP}^{max} - T_C}{T_0 - T_C} < \frac{\alpha_{BP} - \alpha_{SL}}{\alpha_{BP}}.$$

Der thermische Ausdehnungskoeffizient $\alpha_{SC}$ eines keramischen Supraleiters beträgt typischerweise etwa $10 \cdot 10^{-6}$/K, und derjenige eines Bypass aus Stahl $\alpha_{BP}$ rund $15 \cdot 10^{-6}$/K. Mit $T_C \approx 120$ K und $T_0 \approx 300$ K ergibt sich aus obiger Abschätzung ein akzeptabler Temperaturgradient $T_{BP}^{max} - T_c$ von 60 K. Die Anordnung muss also so ausgelegt sein, dass $T_{BP}$ nicht über 180 K steigt. Die im Leiterverbund erzeugte Wärme muss also ausreichend schnell abgeführt werden, und/oder der die Wärme erzeugende Fehlerstrom muss rasch unterbrochen werden. Lassen sich grössere Temperaturdifferenzen nicht vermeiden, sind die genannten Werte für $\alpha_{SC}$ und/oder $\alpha_{BP}$ entsprechend zu modifizieren.

Unter Einbezug der im Leiterverbund tatsächlich auftretenden Kräfte F, welche bis auf das Vorzeichen gleich gross und entgegengesetzt sind, wird die erste Ungleichung ersetzt durch die Bedingung, dass die spezifische Längenänderung gleich sein muss. A bezeichnet den Querschnitt senkrecht zur Stromflussrichtung und E den Elastizitätsmodul des Bypass/Supraleiters

$$\alpha_{BP} \cdot (T_0 - T_{BP}) - F/(A_{BP} \cdot E_{BP}) = \alpha_{SC} \cdot (T_0 - T_{SC}) + F/(A_{SC} \cdot E_{SC})$$

Die resultierende Längenänderung des Verbundes liegt zwischen den in der ersten Ungleichung aufgeführten Werten für getrennte Komponenten. Die erste Ungleichung stellt eine notwendige Bedingung dar dafür, dass die letztgenannte Gleichung eine Lösung mit F > 0 hat, d.h. sich tatsächlich ein kompressiver Druck auf den Supraleiter einstellt. Bei $T_{SC} = T_0 = T_{BP}$ kann die Kraft F einen beliebigen Wert annehmen. Vorspannungen bei $T_0$ sind somit möglich, es lässt sich in diesem Falle aber immer auch eine vorspannungsfreie Temperatur $T_0'$ finden.

Ist nun $T_0$ mit der Herstelltemperatur der Anordnung identisch, wird letztere präpariert, indem bei $T_0$ der Bypass 2 mit dem Supraleiter 1 in Kontakt gebracht wird. Auf einfache Weise geschieht dies ohne Vorspannung der Komponenten, d.h. weder der Supraleiter 1 noch der Bypass 2 stehen bei $T_0$ in Stromflussrichtung I unter Druck oder Spannung. Eine stoffund kraftschlüssige Verbindung wird erreicht mittels einer dünnen Zwischenschicht 20 aus Lot oder einem leitenden Kunststoff wie z.B. Epoxidharz mit Silberpartikeln. Das gleichmässig verteilte Material der Zwischenschicht untergeht eine einmalige Erwärmung respektive ein Aushärten unter Vakuum bei einer Temperatur von 100-300°C. Alternativ dazu sind auch Mittel wie Pressen oder Bandagen denkbar, welche senkrecht zu den Hauptflächen des Supraleiters einen Anpressdruck aufrechterhalten.

BEZUGSZEICHENLISTE

| | |
|---|---|
| 1, 1' | Supraleiter |
| 10, 11 | Hauptflächen |
| 2, 2' | elektrischer Bypass |
| 20 | Zwischenschicht |
| 3 | Isolator |

**Patentansprüche**

1. Hochtemperatursupraleiteranordnung mit einem Supraleiter (1) und einem mit dem Supraleiter (1) in elektrischem und mechanischem Kontakt stehenden elektrischen Bypass (2), wobei sich der Supraleiter (1) auf einer Supraleitertemperatur $T_{SC}$ und der Bypass (2) auf einer Bypasstemperatur $T_{BP}$ befindet, **dadurch gekennzeichnet, dass** der Bypass (2) auch dann in einer Stromflussrichtung (I) einen kompressiven Druck auf den Supraleiter (1) erzeugt, wenn die Supraleitertemperatur $T_{SC}$ unterhalb der Bypasstemperatur $T_{BP}$ liegt.

2. Anordnung nach Anspruch 1, wobei der Supraleiter (1) einen ersten thermischen Ausdehnungskoeffizienten $\alpha_{SC}$ und der Bypass (2) einen zweiten thermischen Ausdehnungskoeffizienten $\alpha_{BP}$ aufweist, **dadurch gekennzeichnet, dass** für eine über der maximalen Betriebstemperatur des Bypass (2) liegende Temperatur $T_0$ gilt:

$$\alpha_{BP} \cdot (T_0 - T_{BP}) > \alpha_{SC} \cdot (T_0 - T_{SC})$$

3. Anordnung nach Anspruch 2, wobei $T_C$ die kritische Temperatur des Supraleiters (1) bezeichnet, **dadurch gekennzeichnet, dass** für die maximale Bypasstemperatur $T_{BP}^{max}$ gilt:

$$\frac{T_{BP}^{max} - T_C}{T_0 - T_C} < \frac{\alpha_{BP} - \alpha_{SC}}{\alpha_{BP}}.$$

4. Anordnung nach Anspruch 1, **dadurch gekennzeichnet, dass** der Supraleiter (1) in Bandform vorliegt und parallel zur Stromflussrichtung (I) zwei Hauptflächen (10,11) aufweist, und dass der Bypass (2) über beide Hauptflächen (10,11) mit dem Supraleiter (1) in Kontakt steht.

5. Anordnung nach Anspruch 4, **dadurch gekennzeichnet, dass** der Supraleiter zwei Schichten umfasst, welche durch einen elektrischen Isolator getrennt sind und in welchen der Strom im Wesentlichen in entgegengesetzter Richtung fliesst.

6. Anordnung nach Anspruch 1, **dadurch gekennzeichnet, dass** der Bypass (2) Stahl umfasst und zwischen dem Supraleiter (1) und dem Bypass (2) eine Lotschicht oder eine elektrisch leitende Klebschicht (20) vorhanden ist.

7. Verfahren zur Herstellung einer Hochtemperatursupraleiteranordnung mit einem Supraleiter (1) und einem mit dem Supraleiter (1) in elektrischem und mechanischem Kontakt stehenden elektrischen Bypass (2), wobei der Supraleiter (1) eine Supraleitertemperatur $T_{SC}$ und einen ersten thermischen Ausdehnungskoeffizienten $\alpha_{SC}$ aufweist und der Bypass (2) eine Bypasstemperatur $T_{BP}$ und einen zweiten thermischen Ausdehnungskoeffizienten $\alpha_{BP}$ aufweist,
**dadurch gekennzeichnet, dass** der Bypass (2) auch dann in einer Stromflussrichtung (I) einen kompressiven Druck auf den Supraleiter (1) erzeugt, wenn die Supraleitertemperatur $T_{SC}$ unterhalb der Bypasstemperatur $T_{BP}$ liegt, und dass der Supraleiter (1) und der Bypass (2) bei einer Herstelltemperatur $T_0$, welche über der maximalen Betriebstemperatur des Bypass (2) liegt, in mechanischen, in Stromflussrichtung (I) drucklosen Kontakt gebracht werden.

8. Verfahren nach Anspruch 7, **dadurch gekennzeichnet, dass** der Bypass (2) Stahl umfasst und durch Verlöten oder Verkleben in Kontakt mit dem Supraleiter (1) gebracht wird.

10  11  2

I  1

2'

Fig. 1

20  2

1

2'

Fig. 2

2

1

I

3

I

1'

2'

Fig. 3